# EUROPÄISCHE PATENTSCHRIFT

(11) **EP 0 973 368 B1**
(45) Veröffentlichungstag und Bekanntmachung des Hinweises auf die Patenterteilung: **26.01.2005**
(21) Anmeldenummer: 99113429.7
(22) Anmeldetag: 12.07.1999
(51) Int. Cl.: H05K 9/00, H05F 1/00, H05F 3/00

(54) **Verpackungsbehälter für elektrostatisch abzuschirmende Gegenstände**
Packing container for objects to be electrostatically shielded
Boîte d'emballage pour objets à protéger électrostatiquement

(30) Priorität: 14.07.1998 DE 29812313 U
(43) Veröffentlichungstag der Anmeldung: 19.01.2000
(73) Patentinhaber: Wolfgang Warmbier Systeme gegen Elektrostatik, 78247 Hilzingen (DE)
(72) Erfinder: Golane, Meir, 78234 Engen (DE)
(74) Vertreter: Behrmann, Niels, Dipl.-Ing.

(56) Entgegenhaltungen:
- DE-A- 4 206 727
- US-A- 4 706 438
- US-A- 5 613 610

## Beschreibung

Die vorliegende Erfindung betrifft einen Verpackungsbehälter für elektrostatisch abzuschirmende Gegenstände nach dem Oberbegriff des Anspruches 1.

In einer Vielzahl von technischen Gebieten wie Luft- und Raumfahrt, Elektronik, Chemie und Medizintechnik werden elektrostatisch abschirmende Verpackungsmaterialien benutzt, die zu verpackendes Transportgut zuverlässig vor elektrostatischen Entladungen (Electrostatic Discharge = ESD) schützen, wobei ESD für zunehmend höher integrierte elektronische Komponenten zu einer steigenden Bedrohung wird. So können etwa im Bereich von VLSI, MOS-Technologie oder MR-Köpfen elektronische Komponenten bereits durch ESD einer Stärke von weniger als 1000 Volt beschädigt werden. Gegenüber einem Totalausfall einer Vorrichtung durch ESD, im Rahmen von Prüffeld bzw. Kontrollmaßnahmen feststellbar, sind darüber hinaus latente ESD-Schäden, die sich erst mittel- bzw. langfristig auf die Funktionsfähigkeit eines elektronischen Schaltkreises auswirken, besonders tückisch und müssen weitestmöglich vermieden werden.

Eine grundsätzliche Lösung besteht darin, auf den jeweiligen Elektronikchips eine elektrostatische Abschirmvorrichtung vorzusehen; hierfür eignen sich jedoch nur ausgewählte Technologien. Üblich geworden ist es daher, ESD-sensible Schaltungen und Bauelemente in speziell vorgesehenen Abschirmverpackungen zu lagern und versenden, die üblicherweise eine elektrostatische Abschirmschicht mit einer durch Kohlenstoff bzw. Graphit realisierten, dünnen Leiterschicht aufweisen. Eine derartige Abschirmschicht führt jedoch in der Praxis zu zahlreichen Problemen. Nicht nur ist die elektrostatische Abschirmwirkung dieses Materials nicht ausreichend, insbesondere hohe elektrostatische Felder auf ein verträgliches Maß im Behälterinneren herabzusetzen, auch führt die bekannte Kohlenstoffschicht zu nicht unbeträchtlichen Problemen bei der Entsorgung, da sie üblicherweise ein Trennen von dem verbleibenden (Papier- bzw. Papp-) Werkstoff verlangt, bevor dieser umweltgerecht entsorgt werden kann.

Basis für die bekannte Abschirmtechnologie sind der ämerikanische Standard EOS/ESD-Energytest sowie der neue internationale Standard IEC 61340-5-1-TR2.

Gattungsgemäße Vorrichtungen sind zudem aus der deutschen Patentschrift 42 06 727 C2 der Anmelderin bekannt, die eine mehrschichtige Werkstoffbahn für herkömmliche Verpackungsbehälter mit einer Mehrschichtstruktur bestehend aus einer Innen- und einer Außenschicht sowie einer zwischen diesen verlaufenden elektrostatischen Abschirmschicht aus leitfähigem Material offenbart. Bei dieser bekannten Vorrichtung aus dem Stand der Technik ist die elektrostatische Abschirmschicht aus Papier oder Faservlies realisiert, welches hochleitfähige Fasern aufweist.

Derartige bekannte Vorrichtungen zeichnen sich -- im Gegensatz zur Kohlenstoffschicht -- durch gute elektrostatische Abschirmungseigenschaften aus, weisen jedoch den Nachteil auf, daß insbesondere die eigentliche Abschirm-(Faser-) schicht in ihrer Herstellung recht aufwendig ist und dadurch hohe Produktionskosten verursacht.

Aufgabe der vorliegenden Erfindung ist es daher, einen gattungsgemäßen Verpackungsbehälter zu schaffen, dessen Abschirmschicht -- ohne Verschlechterung ihrer elektrostatischen Abschirmeigenschaften -- mit weniger Aufwand herzustellen ist und insbesondere eine preisgünstige, flexible Großserienfertigung gestattet.

Die Aufgabe wird durch den Verpackungsbehälter mit den Merkmalen des Anspruches 1 gelöst.

In erfindungsgemäß vorteilhafter Weise wird dabei die Abschirmschicht durch eine Trägerlage bzw. Trägerschicht realisiert, die mit einer dünnen metallischen Beschichtung einer Dicke zwischen 3nm (30 Angström) und 30nm (300 Angström) (1 Angström = 0,1 Nanometer) beschichtet ist.

Nicht nur ermöglicht es eine derartige Schicht, die mit üblichen physikalischen und/oder chemischen Beschichtungsverfahren hergestellt ist, den für eine wirksame Abschirmung notwendigen Oberflächenwiderstand von weniger als 100 Ohm zu erreichen; auch erreicht eine derartige Vorrichtung im praktischen Betrieb generell eine Hochfreqenzdämpfung 1 MHZ bis 1 GHZ von mehr als 60 dB, womit bei üblichen elektrostatischen Aufladungen die Spannung im Behälterinneren stets kleiner als 50 Volt gehalten werden kann.

Darüber hinaus wirkt sich eine derart dünne Beschichtung in praktisch nicht mehr meßbarer Weise als Metallbelastung eines erfindungsgemäß geschaffenen, mehrlagigen Verpackungsbehälters aus, so daß dieser Behälter problemlos und ohne aufwendige Trennverfahren mit Altpapier bzw. Altpappe entsorgt werden kann.

Vorteilhafte Weiterbildungen der Erfindung sind in den Unteransprüchen beschrieben.

So ist es besonders bevorzugt, die Abschirmschicht so auszubilden, daß diese einen Oberflächenwiderstand < 20 Ohm, und weiter bevorzugt zwischen 5 und 10 Ohm aufweist.

Als Trägerschicht hat sich besonders bevorzugt eine Papierlage eines spezifischen Gewichts < 100 g/m², weiter bevorzugt < 50 g/m² erwiesen.

Besonders geeignete metallische Beschichtungen werden im Rahmen bevorzugter Weiterbildungen der Erfindung mit besonders hochleitfähigen Metallen durchgeführt.
Im Rahmen der vorliegenden Erfindung liegt es zudem, weiterbildungsgemäß die Verpackungsbehälter mit mindestens einer dissipativen Deckschicht zu versehen, die zur Verhinderung reibungsbedingter elektrostatischer Aufladungen an den Oberflächen vorgesehen ist.

Als Papier im Rahmen der vorliegenden Erfindung, insbesondere betreffend die erfindungsgemäße Trägerschicht, soll jegliches Faser- bzw. Zellulosematerial verstanden werden, welches sich zur Beschichtung mit einer erfindungsgemäßen dünnen Metallschicht eignet.

Unabhängiger Schutz im Rahmen der vorliegenden Erfindung wird beansprucht für einen mehrlagige Werkstoff, die eine elektrisch leitfähige Abschirmschicht gemäß Hauptanspruch aufweist.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: eine Schnittansicht durch eine mehrlagige Werkstoffbahn eines Verpackungsbehälters mit einer elektrisch leitfähigen Abschirmschicht gemäß einer ersten Ausführungsform der Erfindung;
- Fig. 2:: eine Perspektivansicht eines Verpackungsbehälters zum Aufnehmen elektrostatisch abzuschirmender Gegenstände, die unter Verwendung einer Werkstoffbahn gemäß Fig. 1 hergestellt wurde;
- Fig. 3:: eine Schrägansicht auf eine alternative Ausführungsform eines erfindungsgemäßen Verpackungsbehälters in geöffnetem Zustand;
- Fig. 4:: eine mehrlagige Werkstoffbahn gemäß einer zweiten Ausführungsform, die zur Realisierung des erfindungsgemäßen Verpackungsbehälters Einsatz findet;
- Fig. 5:: eine schematische Ansicht einer Versandtasche, welche bevorzugt unter Verwendung der in Fig. 4 gezeigten Werkstoffbahn hergestellt wurde.

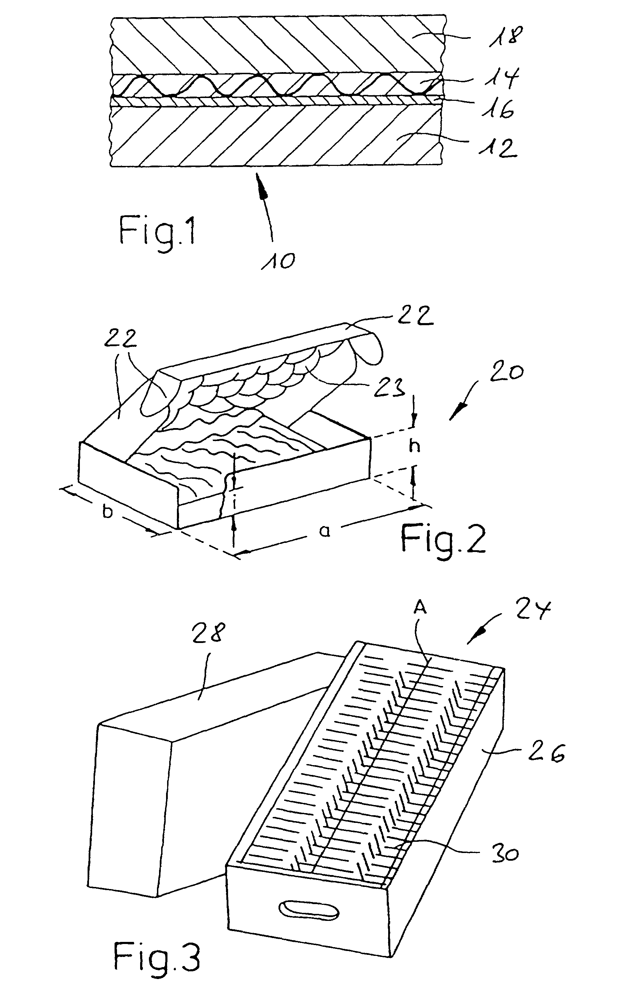

Eine in Fig. 1 in der Schnittansicht gezeigte mehrlagige Werkstoffbahn 10 ist aus einer ersten äußeren Trägerschicht 18, einer gewellten Zwischenlage 14, einer elektrostatisch abschirmenden Abschirmschicht 16 sowie einer zweiten äußeren Trägerschicht 12 aufgebaut. Um die gewünschten elektrostatischen Abschirmeigenschaften zu erreichen, ist die Lage der hochleitfähigen Abschirmschicht im Gesamtaufbau 10 von geringer Bedeutung. So kann die Abschirmschicht 16 zwischen der äußeren Trägerschicht 18 und der gewellten Zwischenlage 14, als auch zwischen der äußeren Trägerschicht 12 und der gewellten Zwischenlage 14 eingebettet sein. Außerdem kann die Abschirmschicht 16 in oder auf der äußeren Trägerschicht 12 bzw. 18 oder der gewellten Zwischenlage 14 maschinell eingearbeitet sein. Die äußeren Trägerschichten 12, 18 sind dabei mit einer dissipativen Beschichtung bzw. Lackierung (Bedruckung) versehen, die den im gezeigten Ausführungsbeispiel aus einem Papp- bzw. Papiermaterial realisierten Schichten einen Oberflächenwiderstand zwischen etwa 10⁶ und etwa 10¹¹ Ohm gibt und zur Verhinderung von reibungsbedingten elektrostatischen Aufladungen an den jeweiligen Außenflächen geeignet ist. Das Papp- bzw. Papiermatrial für die Trägerschichten 12 bzw. 18 weist zum Erreichen gewünschter Festigkeits- bzw. Steifigkeitseigenschaften ein spezifisches Gewicht zwischen etwa 100 und 200 g/m², weiter bevorzugt zwischen 120 und 150 g/m², und im konkreten Ausführungsbeispiel von ca. 150 g/m² auf.

Die gewählte Zwischenlage 14 ist in üblichen Korrugationsgrößen B, E oder F gewählt und weist ein spezifisches Gewicht zwischen etwa 100 und 120 g/m² auf.

Die elektrisch leitfähige Abschirmschicht als elektrostatische Abschirmschicht 16 ist als mit einer dünnen Metallisierung versehene Papierlage realisiert, die mit dieser hochleitfähigen Metallschicht derart beschichtet ist, daß der Oberflächenwiderstand weniger als 100 Ohm beträgt und bevorzugt auf zwischen 5 und 10 Ohm eingestellt ist. Die durch ein geeignetes physikalisches und/oder chemisches Beschichtungsverfahren erreichte Beschichtungsdicke der Metallschicht beträgt zwischen 30 und 300 Angström, wobei die Dicke bevorzugt auf 100 Angström (entspricht 10 Nanometern) eingestellt ist.

Als Beschichtungsmetall wird ein reines Metall oder eine Metallegierung verwendet, die bevorzugt ein hochleitfähiges Metall wie Aluminium, Silber, Kupfer, Eisen oder Gold aufweist.

Im praktischen Versuch erreicht eine derartige elektrostatische Abschirmung eine Verminderung der elektrostatischen Felder im Behälterinneren von weniger als 50 Volt, so daß der beabsichtigte, hochleistungsfähige Abschirmzweck in herausragender Weise erreicht werden kann. Die Hochfrequenzdämpfung im Bereich zwischen 1 MHz bis 1 GHz beträgt stets mehr als 60 dB.

Erfindungsgemäße Behälter, die unter Verwendung der Mehrschichtanordnung in Fig. 1 realisiert wurden, sind in Fig. 2 und Fig. 3 als stabile, belastbare und mehrfach verwendbare Verpackungsbehälter exemplarisch gezeigt, wobei etwa die Anordnung in Fig. 2 aus einem entsprechend gestanzten und gefalteten Bogen der vorbeschriebenen Werkstoffbahn 10 realisiert ist. Die in Fig. 2 dargestellte, quaderförmige Verpackungsbox 20 besitzt eine Breite a von etwa 190 mm, eine Tiefe b von etwa 30 mm und eine Höhe h von etwa 35 mm; zusätzlich enthält die gezeigte Box 20 sowohl im Deckelbereich 22 als auch im Bodenbereich eine (bevorzugt antistatische) Schaumstoffeinlage 23 einer Höhe i. Die gezeigte Box eignet sich in besonders vorteilhafter Weise zum Versenden von Halbleiterbauelementen bzw. von Baugruppen oder Schaltkreisen, die mit ESD-empfindlichen Bauelementen bestückt sind. Auch eine solche Anordnung hat im praktischen Versuch gezeigt, daß elektrostatische Felder einer Größenordnung oberhalb 10 000 Volt auf Werte < 50 Volt im Verpackungsinneren reduziert werden können.

Eine alternative Realisierungsform für einen Verpackungsbehälter ist in Fig. 3 gezeigt. Der Verpackungsbehälter 24 der Fig. 3 aus Bodenteil 26 und abnehmbarem Deckel 28 -- unter Verwendung der Mehrlagenstruktur 10 gemäß Fig. 1 hergestellt -- enthält quer zu seiner Achse A eingebrachte Quereinsätze 30.

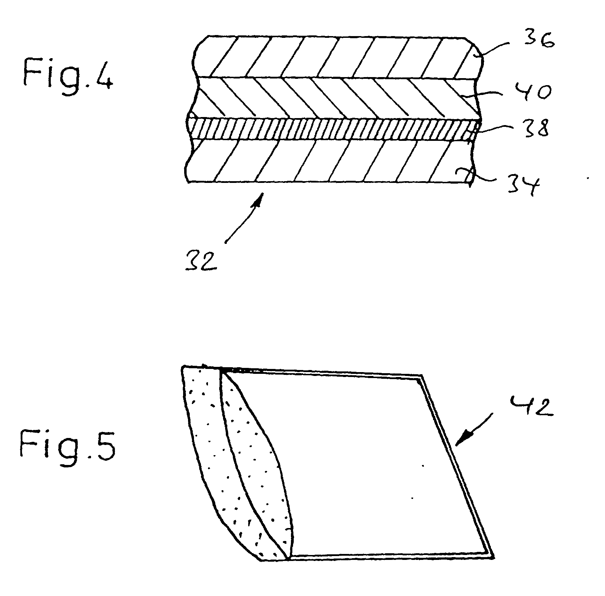

Unter Bezug auf die Fig. 4 wird nunmehr eine alternative Realisierung einer mehrschichtigen Werkstoffbahn für die Herstellung von erfindungsgemäß elektrostatisch abschirmenden Verpackungsbehältern beschrieben.

Eine mehrschichtige Werkstoffbahn 32 gemäß dieser weiteren Ausführungsform besitzt -- wie die im Zusammenhang mit Fig. 1 beschriebene erste Ausführungsform -- eine erste bzw. zweite äußere Trägerschicht 34, 36, die bevorzugt wie im obigen Beispiel dissipativ beschichtet (z. B. bedruckt) sind. Auch ist die hochleitfähige Abschirmschicht 38 in der vorstehend beschriebenen Weise unter Einsatz eines mit einer dünnen Metallbeschichtung versehenen Papierträgers realisiert. Um die gewünschten elektrostatischen Abschirmeigenschaften zu erreichen, ist die Lage der hochleitfähigen Abschirmschicht im Gesamtaufbau 10 von geringer Bedeutung. So kann die Abschirmschicht 16 zwischen der äußeren Trägerschicht 18 und der gewellten Zwischenlage 14, als auch zwischen der äußeren Trägerschicht 12 und der gewellten Zwischenlage 14 eingebettet sein. Außerdem kann die Abschirmschicht 16 in oder auf der äußeren Trägerschicht 12 bzw. 18 oder der gewellten Zwischenlage 14 maschinell eingearbeitet sein.

Im Gegensatz zur ersten Ausführungsform ist jedoch zwischen der Abschirmschicht 38 und der zweiten äußeren Trägerschicht 36 eine Fütterungs- bzw. Polsterschicht 40 vorgesehen, die -- als flexible, nachgebende und stoßaufnehmende Fütterung -- aus Papierschnitzeln bzw. geshreddertem Papiermaterial besteht; geeignet weist diese Polsterschicht 40 ein spezifisches Gewicht zwischen etwa 100 und 200 g/m², bevorzugt zwischen 130 und 150 g/m², auf. Einzelstücke des maschinell geshreddertem Papiers besitzen bevorzugt etwa eine Länge von 15 mm bei einer Breite von etwa 2 mm.

Die vorteilhaften Recycliereigenschaften im Rahmen der vorliegenden Erfindung werden insbesondere durch eine kurze Abschätzung plausibel, die den Metallanteil an einer zu rezyklierenden Beschichtung feststellt. So betragen jeweils pro Quadratmeter die ca. Gewichte der Schichten 12 bis 18 in Fig. 1:

| | |
|---|---|
| obere äußere Trägerschicht 18 | 150 g |
| gewellte Lage 14 | 140 g |
| Papierträger für Abschirmschicht 16 | 40 g |
| Aluminiumbeschichtung der Lage 16 | 0,03 g |
| untere äußere Trägerschicht 12 | 150 g |
| Gesamtgewicht | 480 g |
| davon Aluminiumanteil | 62 PPM (Teile per einer Mio.) |

Dieses Beispiel zeigt, daß der Metallanteil in einem zu rezyklierenden Abschirmbogen gegenüber dem Papier- bzw. Pappkomponenten vollständig zu vernachlässigen ist und sich in keiner Weise nachteilig auf die Umweltfreundlichkeit des erfindungsgemäßen Verpackungsbehälters auswirkt.

## Patentansprüche

1. Verpackungsbehälter (20, 24, 42) für elektrostatisch abzuschirmende Gegenstände mit einem eine elektrisch leitfähige Abschirmschicht (16, 38) aufweisenden mehrlagigen Verpackungswerkstoff (10, 32), wobei die Abschirmschicht einen Oberflächenwiderstand von weniger als 100 Ohm aufweist,
**dadurch gekennzeichnet,**
**daß** die Abschirmschicht (16, 38) eine aus Papier gebildete Trägerschicht aufweist, die mit einer metallischen Beschichtung einer Dicke von zwischen 3nm (30 Angström) und 30nm (300 Angström) beschichtet ist.

2. Behälter nach Anspruch 1, **dadurch gekennzeichnet, daß** die Abschirmschicht einen Oberflächenwiderstand von weniger als 50 Ohm, bevorzugt zwischen 5 und 20 Ohm, und weiter bevorzugt zwischen 5 und 10 Ohm, aufweist.

3. Behälter nach Anspruch 1 oder 2, **dadurch gekennzeichnet, daß** die Trägerschicht ein spezifisches Gewicht zwischen 25 und 100 g/m², insbesondere zwischen 30 und 50 g/m², aufweist.

4. Behälter nach einem der Ansprüche 1 bis 3, **dadurch gekennzeichnet, daß** die metallische Beschichtung aus einem Metall oder einer Metallegierung realisiert ist, die aus der Gruppe bestehend aus Al, Ag, Cu, Fe, Au sowie Legierungen von diesen ausgewählt ist.

5. Behälter nach einem der Ansprüche 1 bis 4, **gekennzeichnet durch** mindestens eine dissipative Deckschicht, die einen Oberflächenwiderstand im Bereich zwischen 10⁶ und 10¹¹ Ohm aufweist.

6. Behälter nach Anspruch 5, **dadurch gekennzeichnet, daß** die Deckschicht (12, 18) mittels einer Beschichtung oder durch Bedrucken realisiert ist.

7. Behälter nach einem der Ansprüche 1 bis 6, **gekennzeichnet durch** eine mit einer Mehrzahl von Papier- bzw. Zellulosestücken realisierte, mechanisch nächgebende Polsterschicht (40) als Bestandteil des Verpackungswerkstoffes.

8. Mehrlagiger Verpackungswerkstoff, insbesondere zur Verwendung in einem Verpackungsbehälter nach einem der Ansprüche 1 bis 7, mit einer elektrisch leitfähigen Abschirmschicht, die einen Oberflächenwiderstand von weniger als 10² Ohm aufweist, **dadurch gekennzeichnet, daß** die Abschirmschicht eine aus Papier gebildete Trägerschicht aufweist, die mit einer metallischen Beschichtung eine Dicke von zwischen 3nm (30 Angström) und 30nm (300 Angström) beschichtet ist.

## Claims

1. Packaging container (20, 24, 42) for objects to be screened electrostatically with a multi-layered packaging material (10, 32) having an electrically conductive screening layer (16, 38), wherein the screening layer has a surface resistance of less than 100 ohm, **characterised in that** the screening layer (16, 38) has a support layer formed from paper, which is coated with a metallic coating of a thickness of between 3 nm (30 Ångström) and 30 nm (300 Ångström).

2. Container according to claim 1, **characterised in that** the screening layer has a surface resistance of less than 50 ohm, preferably between 5 and 20 ohm, and also preferably between 5 and 10 ohm.

3. Container according to claim 1 or 2, **characterised in that** the support layer has a specific weight between 25 and 100 g/m², in particular between 30 and 50 g/m².

4. Container according to one of claims 1 to 3, **characterised in that** the metallic coating is realised from a metal or a metal alloy which is selected from the group consisting of Al, Ag, Cu, Fe, Au and alloys of the latter.

5. Container according to one of claims 1 to 4, **characterised by** at least one dissipative cover layer which has a surface resistance in the range between 10⁶ and 10¹¹ ohm.

6. Container according to claim 5, **characterised in that** the cover layer (12, 18) is realised by means of a coating or by printing.

7. Container according to one of claims 1 to 6, **characterised by** a mechanically yielding buffer layer (40), realised by a plurality of paper or cellulose pieces, as a constituent of the packaging material.

8. Multi-layered packaging material, in particular for use in a packaging container according to one of claims 1 to 7, having an electrically conductive screening layer which has a surface resistance of less than 10² ohm, **characterised in that** the screening layer has a support layer formed from paper, which is coated with a metallic coating of a thickness of between 3 nm (30 Ångström) and 30 nm (300 Ångström).

## Revendications

1. Boîte d'emballage (20, 24, 42) pour des objets devant être protégés de l'électricité statique avec
une matière d'emballage multicouche (10, 32) comportant une couche de protection électroconductrice (16, 38), dans laquelle la couche de protection comporte une résistance de surface de moins de 100 ohms,
**caractérisée en ce que**,
la couche de protection (16, 38) comporte une couche de support faite de papier, qui est recouverte d'un revêtement métallique d'une épaisseur comprise entre 3 nm (30 angströms) et 30 nm (300 angströms).

2. Boîte selon la revendication 1, **caractérisée en ce que** la couche de protection comporte une résistance de surface de moins de 50 ohms, de préférence entre 5 et 20 ohms, et particulièrement de préférence entre 5 et 10 ohms.

3. Boîte selon la revendication 1 ou 2, **caractérisée en ce que** la couche de support comporte un poids spécifique compris entre 25 et 100 g/m², en particulier entre 30 et 50 g/m².

4. Boîte selon l'une des revendications 1 à 3, **caractérisée en ce que** le revêtement métallique est réalisé dans un métal ou dans un alliage de métal choisi dans le groupe composé de Al, Ag, Cu, Fe, Au ainsi que des alliages de ceux-ci.

5. Boîte selon l'une des revendications 1 à 4, **caractérisée par** au moins une couche de recouvrement dissipative qui comporte une résistance de surface dans la gamme comprise entre 10⁶ et 10¹¹ ohms.

6. Boîte selon la revendication 5, **caractérisée en ce que** la couche de recouvrement (12, 18) est réalisée au moyen d'un revêtement ou par une impression.

7. Boîte selon l'une des revendications 1 à 6, **caractérisée par** une couche de rembourrage (40) mécaniquement extensible, faite d'une pluralité de morceaux de papier ou selon le cas, de morceaux de cellulose, comme composante de la matière d'emballage.

8. Matière d'emballage multicouche, notamment pour une utilisation dans une boîte d'emballage selon l'une des revendications 1 à 7, avec une couche de protection électroconductrice, qui comporte une résistance de surface de moins de 10² ohms, **caractérisée en ce que** la couche de protection comporte une couche de support faite de papier qui est recouverte d'un revêtement métallique d'une épaisseur comprise entre 3 nm (30 angströms) et 30 nm (300 angströms).
